# EUROPEAN PATENT APPLICATION

(11) **EP 2 426 737 A1**
(43) Date of publication of application: **07.03.2012**
(21) Application number: 10175285.5
(22) Date of filing: 03.09.2010
(51) Int. Cl.: H01L 31/075, H01L 31/18

(54) **Thin-film solar fabrication process, deposition method for solar cell precursor layer stack, and solar cell precursor layer stack**

(71) Applicant: Applied Materials, Inc., Santa Clara, CA 95054 (US)
(72) Inventor: Klein, Stefan, 63743, Aschaffenburg (DE); Schwanitz, Konrad, 63739, Aschaffenburg (DE); Stolley, Tobias, 61440, Oberursel (DE)
(74) Representative: Zimmermann & Partner

(57) **Abstract**

A method of manufacturing a layer stack adapted for a thin-film solar cell and a precursor for a solar cell are described. The method includes depositing a TCO layer over a transparent substrate, depositing a first conductive-type layer, wherein the depositing includes: providing for a first SiOx-containing anti-reflection layer by chemical vapor deposition. The method further includes depositing a first intrinsic-type layer and depositing a further conductive-type layer with a conductivity opposite to the first conductive-type layer.

## Description

### BACKGROUND OF THE INVENTION

### Field of the Invention

Embodiments of the present invention generally relate to depositing layers of a photoelectric conversion module, e.g., a thin-film solar cell. Particularly, they relate to a layer stack of a solar cell, e.g., a solar cell with a one or more p-i-n junctions or n-i-p junctions. Specifically, they relate a method of manufacturing a layer stack adapted for a thin-film solar cell and a precursor for a solar cell.

### Description of the Related Art

Crystalline silicon solar cells and thin-film solar cells are two types of solar cells. Crystalline silicon solar cells typically use either mono-crystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-i-n junctions. Suitable substrates include glass, metal, and polymer substrates.

To expand the economic uses of solar cells, efficiency must be improved. Solar cell stabilized efficiency relates to the proportion of incident radiation converted into usable electricity. For solar cells to be useful for more applications, solar cell efficiency must be improved beyond the current best performance of approximately 10% for Si based thin-film solar modules. With energy costs rising, there is a need for improved thin-film solar cells and methods and apparatuses for forming the same in a factory environment.

In order to improve the efficiency of a solar cell, the amount of photons entering a solar cell layer stack, which are converted into electron-hole pairs should, be increased.

Another aspect for improving mass production of solar cells is the use of large scale processes, increasing the throughput, and improving the reliability at which processes can be conducted. Thus, there is a desire to improve the processes for increasing the efficiency on a large scale and for applications during industrial manufacturing.

### SUMMARY OF THE INVENTION

In light of the above, a method of manufacturing a layer stack adapted for a thin-film solar cell according to independent claim 1 and a precursor for a solar cell according to independent claim 7 are provided.

Embodiments of the invention provide methods of depositing layer stacks for photoelectric conversion devices, e.g., solar cells. According to one embodiment, a method of manufacturing a layer stack configured for an optoelectronic conversion module is provided. The method includes depositing a TCO layer over a transparent substrate and depositing a first conductive-type layer The depositing of the first conductive-type layer includes providing for a first SiOx-containing anti-reflection layer by chemical vapor deposition. The method further includes depositing a first intrinsic-type layer, and depositing a further conductive-type layer with a conductivity opposite to the first conductive-type layer.

According to another embodiment, a precursor for an optoelectronic conversion module is provided. The precursor includes a transparent substrate, a TCO layer deposited over the substrate, a first conductive-type layer, wherein the first conductive-type layer includes: a first SiOx-containing anti-reflection layer deposited by chemical vapor deposition. The precursor further includes a first intrinsic-type layer and a further conductive-type layer with a conductivity opposite to the first conductive-type layer.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1A is a schematic side-view of a layer stack configured for a thin-film solar cell according to one embodiment of the invention;

Figure 1B is a schematic side-view of a tandem-junction thin-film solar cell according to one embodiment of the invention;

Figures 2 is a schematic side-view of a further thin-film solar cell according to one embodiment of the invention;

Figures 3 is a schematic side-view of a yet further a tandem-junction thin-film solar cell according to one embodiment of the invention;

Figure 4 is a flow-chart illustrating methods of manufacturing a solar cell precursor according to embodiments described herein;

Figures 5A to 5H illustrate the layers deposited on a substrate according to embodiments described herein;

Figure 6 is a flow-chart illustrating methods of manufacturing a solar cell precursor according to embodiments described herein;

Figure 7 illustrates a plan view of a cluster tool that may be used according to one embodiment described herein; and

Figure 8 is a cross-sectional side view of a deposition chamber which can be used according to one embodiment described herein.

To facilitate understanding, identical reference numerals have been used, where possible, to designate identical or similar elements that are common to the figures. It is contemplated that elements and features of one embodiment may be beneficially incorporated into other embodiments without further recitation.

It is to be noted, however, that the appended drawings illustrate only exemplary embodiments of this invention and are, therefore, not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g., a wafer, a transparent substrate, or a glass substrate such as a glass plate, and flexible substrates such as webs and foils.

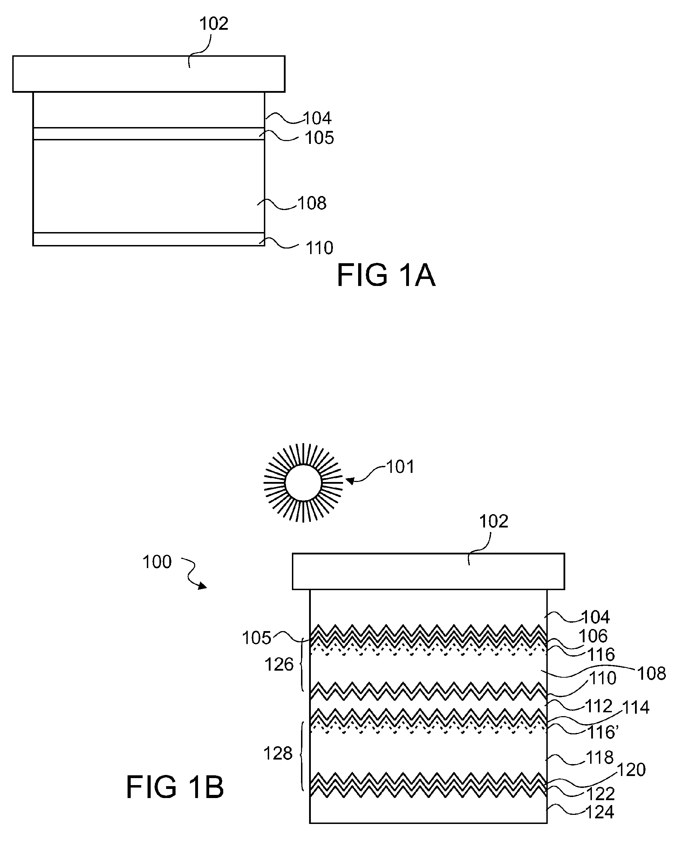

Embodiments described herein relate to a solar cell precursor and methods of manufacturing thereof, wherein a first conductivity-type layer includes a SiOx containing anti-reflection layer. Thereby, reference is, for example, made to the solar cells as described below and explained in further detail with respect to Fig. 1B.

Thin-film solar cells are generally formed from numerous types of films, or layers, combined in many different ways. Most films used in such devices incorporate a semiconductor element that may include silicon, germanium, carbon, boron, phosphorous, nitrogen, oxygen, hydrogen, and the like. Characteristics of the different films include degree of crystallinity, dopant type, dopant concentration, film refractive index, film extinction coefficient, film transparency, film absorption, and conductivity. Typically, most of these films can be formed by use of a chemical vapor deposition process, which may include some degree of ionization, plasma formation and/or sputtering processes.

The term "coating" and the term "depositing" are used synonymously herein. The terms "CVD installation" and "deposition apparatus" are used synonymously herein and shall embrace, for example, an apparatus which uses CVD processes for depositing material, typically as a thin film, on a substrate.

According to different embodiments, a plurality of films can be used in solar cells. Charge generation during a photovoltaic process is generally provided by a bulk semiconductor layer, such as a silicon-containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon", in general and as used herein, may refer to any form of silicon having a crystal phase, including microcrystalline and nanocrystalline silicon. Nevertheless, some embodiments described herein, may refer to specific forms of crystallinity in order to distinguish over other forms of crystallinity.

Fig. 1A shows a layer stack configured for use in an optoelectronic conversion module, such as a thin-film layer cell, a TFT of a display, an optoelectronic diode or the like. The layer stack includes a substrate 102, such as a transparent substrate, which can be a glass substrate, polymer substrate, or other suitable substrate, with thin films formed thereover. The layer stack, e.g., a precursor for a solar cell, further includes a first transparent conducting oxide (TCO) layer 104 formed over the substrate 102, and a junction, which can be a p-i-n junction or an n-i-p junction formed over the first TCO layer 104. According to embodiments described herein, the junction includes a first conductive-type layer 105 (e.g., a p-layer), an intrinsic-type layer 108, and a second conductive-type layer 110 with a conductivity opposite to the first conductive-type layer (e.g., an n-layer). Thereby, the first conductive type layer 105 shown in Fig. 1A is a doped SiOx layer, which is deposited in a CVD processing system for depositing the junction and which can include at least 50% by weight of SiOx. Further, the doped SiOx layer can be tuned to have a refraction index between 2 and 4, e.g. 3, such that the SiOx layer can act as an anti-reflection layer. Yet further, according to some embodiments, it is also possible to influence the crystal fraction of the SiOx layer such that the crystallinity of the SiOx-layer can be between the crystallinity of the TCO layer and the i-type layer. Thus, having an SiOx layer as part of a first conductive-type layer allows for improving optical properties, improving growth of the layer stack, and improving electrical properties of the layer stack.

As shown for other embodiments described herein, the precursor for a thin-film solar cell as shown in Fig. 1A can further include a back contact layer (not shown in Fig. 1A). The metal back layer may include, but is not limited to a material selected from the group consisting of Al, Ag, Ti, Cr, Au, Cu, Pt, alloys thereof, or combinations thereof. According to typical implementations, a scribing process such as a laser scribing process can further be performed to form the solar cell. Other films, materials, substrates, and/or packaging may be provided over the metal back layer to complete the solar cell device. The formed solar cells may be interconnected to form modules, which in turn can be connected to form arrays.

FIG. 1B is a schematic diagram of an embodiment of a multi-junction solar cell 100 oriented toward the light or solar radiation 101. Solar cell 100 includes a substrate 102, such as a glass substrate, polymer substrate, metal substrate, or other suitable substrate, with thin films formed thereover. The solar cell 100 further includes a first transparent conducting oxide (TCO) layer 104 formed over the substrate 102, and a first p-i-n junction 126 formed over the first TCO layer 104. In one configuration, a wavelength selective reflector (WSR) layer 112 is formed over the first p-i-n junction 126. A second p-i-n junction 128 is formed over the first p-i-n junction 126, a second TCO layer 122 is formed over the second p-i-n junction 128, and a metal back layer 124 is formed over the second TCO layer 122. In one embodiment, a WSR layer 112 is disposed between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin films formed thereover may be optionally textured by wet, plasma, ion etching, and/or mechanical processes. For example, in the embodiment shown in FIG. 1B, the first TCO layer 104 is textured and the subsequent thin films deposited thereover will generally follow the topography of the surface below it.

According to some embodiments described herein, a further layer such as a buffer layer is deposited between the substrate 102 and the TCO layer 104. Thereby, typically, the further layer can be a SiON-containing layer. The further layer is provided in order to have an improved nucleation of the transparent conductive oxide (TCO) layer, such as a ZnO-containing TCO layer. Accordingly, the substrate including, e.g., a buffer layer is conditioned for improved ZnO growth. According to embodiments described herein, the further layer includes a metal such as Al, Ti, Zn, or the like. Thereby, nucleation of the TCO layer can be influenced to provide for improved texturing and desired electrical and optical properties of the TCO layer. According to some embodiments, the conditioning can be conducted by depositing or preparing a metal-containing layer, e.g., that the layer is doped with a metal.

The first TCO layer 104 and the second TCO layer 122 may each include tin oxide, zinc oxide, indium tin oxide, cadmium stannate, combinations thereof, or other suitable materials. It is understood that the TCO materials may also include additional dopants and components. For example, zinc oxide may further include dopants such as aluminum, gallium, boron, and other suitable dopants. Zinc oxide preferably includes 5 atomic % or less of dopants, and more preferably includes 2.5 atomic % or less aluminum. In certain instances, the substrate 102 may be provided by the glass manufacturers with the first TCO layer 104 already provided.

The first p-i-n junction 126 may include a p-type amorphous silicon layer 106, an intrinsic-type amorphous silicon layer 108 formed over the p-type amorphous silicon layer 106, and an n-type microcrystalline silicon layer 110 formed over the intrinsic-type amorphous silicon layer 108.

According to further embodiments, which can be combined with other embodiments described herein, the first p-i-n junction 126 may include an optional p-i buffer-type intrinsic amorphous silicon (PIB) layer 116 that is formed over the p-type silicon layer 106. In certain embodiments, the p-i buffer-type intrinsic amorphous silicon (PIB) layer 116 may be formed to a thickness between about 50 Å and about 500 Å.

According to embodiments described herein, an anti-reflections layer 105 is deposited within the p-type layer or as a part of the p-type layer, i.e., the first layer of the p-i-n junction or an n-i-p junction of the first conductive-type.

In certain embodiments, the p-type amorphous silicon layer 106 may be formed to a thickness between about 60Å and about 300Å. In certain embodiments, the intrinsic-type amorphous silicon layer 108 may be formed to a thickness between about 1,500Åand about 3,500Å. In certain embodiments, the n-type microcrystalline semiconductor layer 110 may be formed to a thickness between about 100Å and about 400Å.

The WSR layer 112 disposed between the first p-i-n junction 126 and the second p-i-n junction 128 is generally configured to have certain desired film properties. In this configuration, the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (e.g., 400 nm to 700 nm) in the first p-i-n junction 126 and improves short-circuit current, resulting in improved quantum and conversion efficiency. Further, the WSR layer 112 has high film transmittance for mid to long wavelengths of light (e.g., 500nm to 1100nm) to facilitate the transmission of light to the layers formed in the junction 128. Further, it is generally desirable for the WSR layer 112 to absorb as little light as possible while reflecting desirable wavelengths of light (e.g., shorter wavelengths) back to the layers in the first p-i-n junction 126 and transmitting desirable wavelengths of light (e.g., longer wavelengths) to the layers in the second p-i-n junction 128.

In one embodiment, the WSR layer 112 may include an n-type doped silicon alloy layer, such as silicon oxide (SiOₓ, Si02), silicon carbide (SiC), silicon oxynitride (SiON), silicon nitride (SiN), silicon carbon nitride (SiCN), silicon oxycarbide (SiOC), silicon oxycarbon nitride (SiOCN), or the like. In an exemplary embodiment, the WSR layer 112 is an n-type SiON or SiC layer.

The second p-i-n junction 128 may include a p-type microcrystalline silicon layer 114 and, in some cases, an optional p-i buffer-type intrinsic amorphous silicon (PIB) layer 116' that is formed over the p-type microcrystalline silicon layer 114. Subsequently, an intrinsic-type microcrystalline silicon layer 118 is formed over the p-type microcrystalline silicon layer 114, and an n-type amorphous silicon layer 120 is formed over the intrinsic type microcrystalline silicon layer 118. In certain embodiments, the p-type microcrystalline silicon layer 114 may be formed to a thickness between about 100Å and about 400Å. In certain embodiments, the p-i buffer-type intrinsic amorphous silicon (PIB) layer 116' may be formed to a thickness between about 50 Å and about 500 Å. In certain embodiments, the intrinsic-type microcrystalline silicon layer 118 may be formed to a thickness between about 10,000Å and about 20,000Å. In certain embodiments, the n-type amorphous silicon layer 120 may be formed to a thickness between about 100Å and about 500Å.

The metal back layer 124 may include, but is not limited to a material selected from the group consisting of Al, Ag, Ti, Cr, Au, Cu, Pt, alloys thereof, or combinations thereof. Other processes may be performed to form the solar cell 100, such as laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the pi-n junctions 126, 128 and is converted to electron-hole pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. According to some embodiments, which can be combined with other embodiments described herein, the first p-in junction 126 includes an intrinsic type amorphous silicon layer 108 and the second p-i-n junction 128 includes an intrinsic-type microcrystalline silicon layer 118 since amorphous silicon and microcrystalline silicon absorb different wavelengths of the solar radiation 101. Therefore, the formed solar cell 100 is more efficient, since it captures a larger portion of the solar radiation spectrum. The intrinsic layer 108, 118 of amorphous silicon and the intrinsic layer of microcrystalline silicon are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first pi-n junction 126 continuously transmits through the WSR layer 112 and continues to the second p-i-n junction 128.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally include substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus, hydrogen ratios will include hydrogen used as a carrier gas for dopants.

It has been shown in the past that a difference of the refraction index between the TCO layer, which can, for example, be Sn02 or ZnO and which might be deposited by sputtering, LPCVD, spraying, or others, and the subsequant layer of a silicon solar cell, which is typically deposited with PECVD, results in reflection of photons at the interface of the TCO layer and the first layer of the solar cell. Such reflection losses have been shown to be reduced by introducing, for example, a Ti02 layer, which can be deposited by sputtering. However, such a Ti02 layer would require the use of a further sputtering tool, which results in increased costs efficiency, particularly for large area substrates.

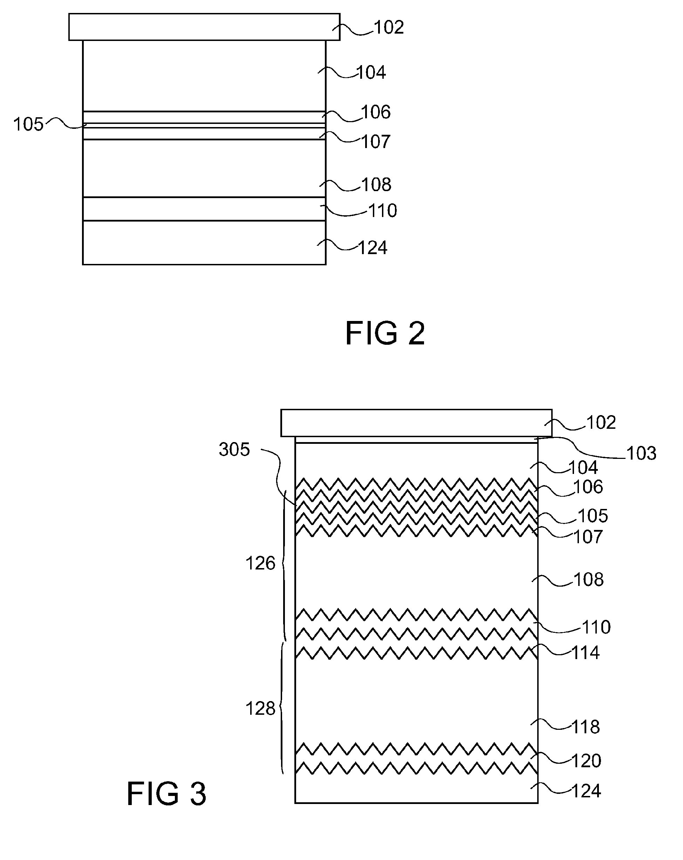

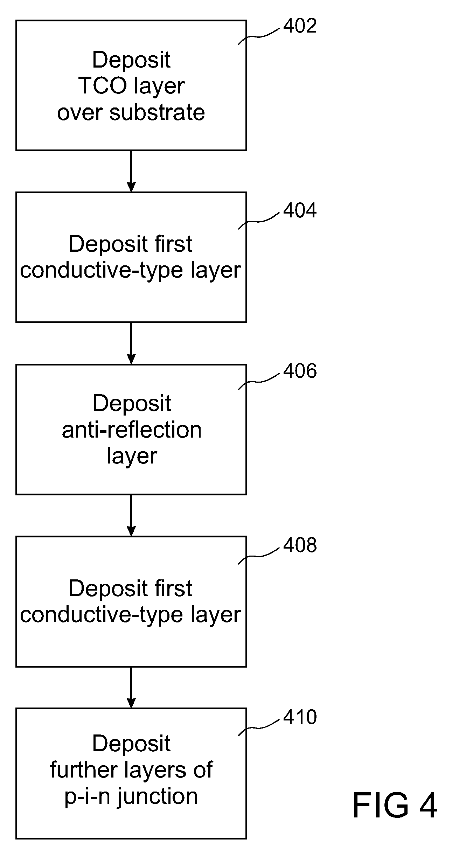

According to different embodiments, a plurality of methods, systems, and apparatus configurations for providing a precursor for a solar cell having an anti-reflection layer as a portion of, adjacent to or within the first conductive-type layer is provided. Figure 2 illustrates one embodiment of a precursor for a solar cell. The corresponding method of manufacturing a layer stack adapted for use in a thin film solar cell, according to embodiments described herein, is described in figure 4. A TCO layer 104 is deposited over a substrate 102. This is shown in figure 2. A corresponding method step is indicated by step 402 in figure 4. In step 404, the first conductive-type layer 106 of the p-i-n junction 126 is deposited. According to typical embodiments, the first conductive-type layer can be a p-type layer.

According to different embodiments, which can be combined with other embodiments described herein, the first conductivity-type layer, the i-layer and the second conductivity-type layer having a conductivity opposite to the first conductivity-type layer form a p-i-n junction or an n-i-p junction, respectively. The examples provided herein generally refer to p-i-n junctions, wherein the first conductivity-type layer is a p-layer and the second conductivity-type layer is an n-layer. It is to be understood that the first conductivity-type layer can also be an n-layer and the second conductivity-type layer can be a p-layer. Thereby, also a p-i-n junctions or an n-i-p junction can be formed.

Typically, the junction 126 is deposited by chemical vapor deposition. In step 406, an anti-reflection layer 105 is deposited. By manufacturing the anti-reflection layer 105 in a CVD tool, i.e., by chemical vapor deposition, a loss due to reflection of photons can be reduced and the anti-reflection layer 105 can be produced cost effectively. Typically, an anti-reflection layer can increase the current in the cell, i.e., the p-i-n junction 126 significantly, e.g., by about 10%. After deposition of the anti-reflection layer 105, the deposition of the first conductive-type layer is continued in step 408. Figure 2 shows the layer 107, which is part of the first conductive-type layer, for example, a p-type layer. The remaining layers of the p-i-n junction 126 are deposited in step 410 such that the i-type layer 108 and that n-type layer 110 are provided as shown in figure 2. Figure 2 further shows a back contact 124.

As described above, the anti-reflection layer is deposited between two further portions of the first conductivity-type layer. According to yet further embodiments, which can be combined with other embodiments described herein, the anti-reflection layer, which is provided as a apart of the first conductivity-type layer, can be deposited as the only layer having the first conductivity type, with one other layer or portion of the first conductivity-type, or with several other layers of the first conductivity type.

According to embodiments, which can be combined with other embodiments described herein, the anti-reflection layer 105 is a SiOx-containing layer. For example, the anti-reflection layer can include a microcrystalline or nanocrystalline SiOx material that can, e.g., be doped. Typically, the microcrystalline silicon oxide material can be p-or n-doped by boron or phosphorus. According to typical embodiments, which can be combined with other embodiments described herein, the refraction index of the anti-reflection layer can be tuned by adjusting or varying the oxygen content of the SiOx material. Accordingly, by providing an anti-reflection layer with an intermediate refraction index reflection losses can be reduced.

Figure 2 shows an embodiment where the reflection layer 105 is deposited as a part of the first conductive-type layer 106/107. For example, the anti-reflection layer can be a part of the p-layer of the p-i-n junction 126. According to alternative embodiments, an anti-reflection layer can also be provided between the TCO layer and the first conductive-type layer. In this case, the oxygen content of the silicon oxide material (e.g., microcrystalline SiOx material) will be adjusted to have a refraction index of the anti-reflection layer which is between the refraction index of the TCO layer and the refraction index of the first conductive-type layer. Generally, for both cases, i.e., an anti-reflection layer between the TCO layer and the first conductive-type layer and an anti-reflection layer within the first conductive-type layer, the anti-reflection layer can be a part of the first conductive-type layer, for example, a p-layer in the p-i-n junction 126.

According to further embodiments, which may be combined with other embodiments described herein, the SiOx-containing anti-reflection layer can be deposited by adding CO₂ in the processing region of the CVD processing chamber. Thereby, according to yet further embodiments, a solar cell precursor having an anti-reflection layer with a refraction index between 4 and 2 can be provided.

Typically, by variation of the oxygen content in the intermediate layer various properties of the layer can be tuned. Thus, according to methods described herein, the CO₂ content in the process gas can be varied for optimizing the process and can typically be in a range of 50 sccm to 300 sccm for manufacturing a GEN 5 module, which results in about 35 sccm/m² per substrate area to about 210 sccm/m² per substrate area. By increasing the CO₂ concentration in the processing region as described above, the refraction index can, for example, be reduced from about 3.0 to about 2.2, while the band gap is increased from about 2.15 eV to about 2.45 eV, the conductivity is reduced from about 1*10⁻³ S/cm² to about 5*10⁻⁹ S/cm², and the crystalline fraction is reduced from about 0.16 to 0.

Figure 3 illustrates further embodiments of a layer stack for a thin-film solar cell, which can be combined with other embodiments described herein. The barrier or buffer layer 103 is deposited on the substrate 102. According to some embodiments described herein, such a further layer such as a buffer layer 103 is deposited between the substrate 102 and the TCO layer 104. Thereby, typically, the further buffer layer can be a SiON-containing layer. The buffer layer is provided in order to have an improved nucleation of the transparent conductive oxide (TCO) layer, such as a ZnO-containing TCO layer. Accordingly, the substrate including, e.g., a buffer layer is conditioned for improved ZnO growth.

According to embodiments described herein, the buffer layer includes a metal such as Al, Ti, Zn, or the like. Thereby, according to some additional or alternative modification, the layer 103 can have a thickness of below 100 nm, for example, a thickness of 20 nm to 100 nm or of 50 nm to 90 nm. According to further embodiments, which can be combined with other embodiments described herein, the layer 103 can have a refraction index which is between the refraction indexes of the two neighboring layers, e.g., the refraction index of the substrate 102 below layer 103 and the refraction index of the TCO layer 104. For example, the refraction index can be from 1.6 to 1.8.

According to yet further embodiments, which can be combined with other embodiments described herein, the layer 103 can be used as a barrier for the diffusion of elements, e.g., a diffusion barrier for sodium (Na), which can be present in the substrate. For example, the layer can be a diffusion barrier which provides improved long-term stability or improved reliability. For example, the layer acting as a diffusion barrier can enable the layer stack to pass a delamination test, such as the hot-tray test. Accordingly, a buffer layer can improve nucleation of the TCO layer to provide for improved texturing and desired electrical, chemical, and optical properties of the TCO layer.

As shown in Fig. 3, a TCO layer is deposited over the barrier layer 103. Thereafter the first p-i-n junction 126 and a second p-i-n junction 128, i.e., a top cell and a bottom cell of a thin-film solar cell layer stack, are deposited. The second p-i-n junction 128 can, for example, be manufactured as described with respect to figure 1B and a back contact layer 124 can be deposited thereon as also described with respect to figures 1 and 2. Further, the intrinsic-type layer 108 and the second conductive-type layer 110 can also be provided as described with respect to figures 1 and 2.

Figure 3 shows the first anti-reflection layer 105 and the second anti-reflection layer 305 being deposited as part of the first conductive-type layer 106/107. According to typical embodiments, the two anti-reflection layers can have a grading of the refraction index to reduce reflection losses. According to yet further embodiments, which can be combined with other embodiments described herein, to doping level, for example, the p-doping level and/or the silane gas flow can be varied from layer 106 to layer 305, further to layer 105, and finally further to layer 107. According to yet further additional or alternative modifications, the gas flow of C02, the gas flow of methane, the power during CVD, and/or hydrogen gas flow can also be varied from one layer to the next layer 106, 305, 105 and 107. Thereby, the crystalline fraction of the layers can be tuned in order to provide a good electrical contact at the ZnO/p-layer-interface and the p-layer/i-type layer- interface. Thereby, a reduction of either the p-doping level or the silane gas flow allows for an increase in crystalline fraction, particularly for an increase of the crystalline fraction at the ZnO/p-layer interface. Further, an increase of either the p-doping level or the silane gas flow typically provides a more amorphous SiOx layer for a good contact at the amorphous silicon i-type layer.

Thus, according to different embodiments, the anti-reflection layers 105 and 305 can be deposited within the first conductive-type layers 106 and 107, e.g., within or as part of a first conductive-type region (e.g. a p-type region). Alternatively, one or more anti-reflection layers can be deposited between the TCO layer 104 and the first conductive-type layer of the p-i-n junction 126. Typically, the one or more anti-reflection layers can be deposited to be a part of the first conductive-type layer, i.e., either being positioned within of the first conductive-type layers or providing an outer layer of the first conductive-type layer region.

According to yet further embodiments, more than the four layers 106, 305, 105, and 107 can be provided to form a first-conductive type region such as a p-type region of the first p-i-n junction. According to some embodiments, which can be combined with other embodiments described herein, a continuous or step-like change of the oxygen content, the p-doping level, the silane gas flow, the methane gas flow, and/or the RF power during CVD deposition (e.g., PECVD deposition) can be provided to deposit a variety of first conductive-type layers with different material properties. These layers can be a µc-Siox-containing layer, a µc SiC-containing layer, a nc-SiOx containing layer, a nc SiC-containing layer, a amorphous SiOx-containing, and a amorphous SiC-containing layer. Typically, these layers can be deposited subsequently going from high crystal fraction of up to 90% at the TCO layer to a completely amorphous layer structure at the amorphous Si(i) absorber layer. According to yet further additional or alternative implementations, these layers can be deposited subsequently for providing a grading in refraction index from about n=2 to about n=4.

In a stacked-layer type photoelectric conversion device, the photoelectric conversion units, i.e., the top cell 126 and the bottom cell 128 are connected in series. The short-circuit current density of the photoelectric conversion device is restricted by the smaller of the current values of the top cell and the bottom cell. Thus, it is beneficial if the current values of the first and second p-i-n junctions are as equal as possible. Nevertheless, both currents should be as high as possible. By providing anti-reflection layers, which are deposited as a µc-SiOx material in a CVD process, cost efficient deposition of layers resulting in an increased amount of photons being absorbed in the top cell and/or the bottom cell can be provided. A variation of the currents in the top cell and the bottom cell with respect to each other can, for example, be provided by having a WSR layer 112 (see, e.g., Fig. 1B) Thereby, the WSR layer should preferably reflect short wavelength photons and should transmit long wavelength photons with minimal loss. Additionally, in light of the fact that the top cell and the bottom cell are connected in series, the intermediate layer 112 should have good conductive properties. Accordingly, a combination of conductivity, reflecting photons of a desired wavelength range, and transmitting photons of another wavelength range is desirable.

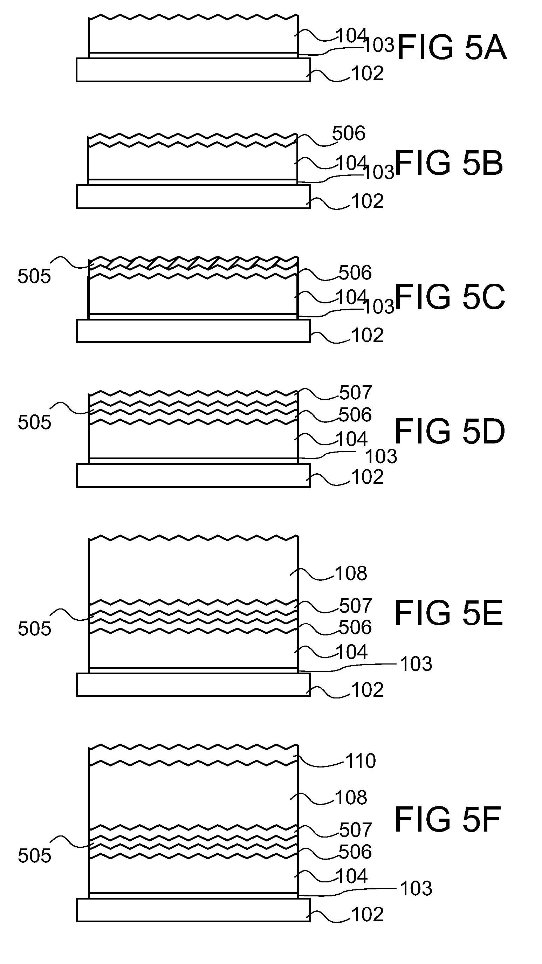

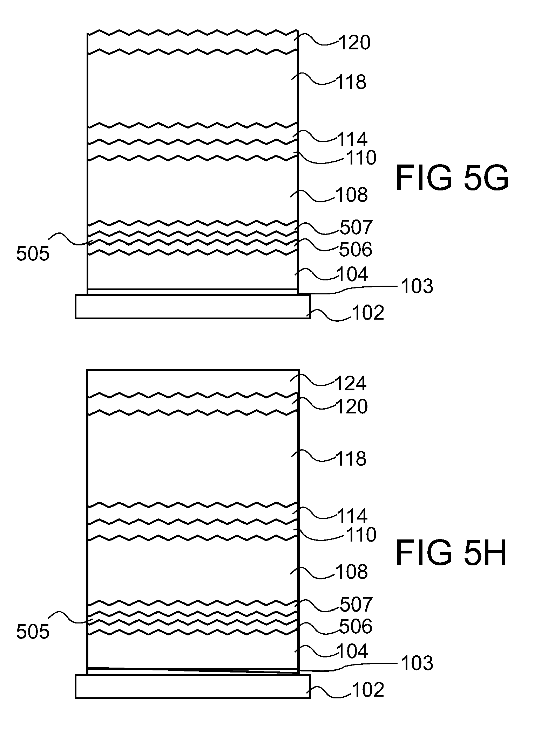

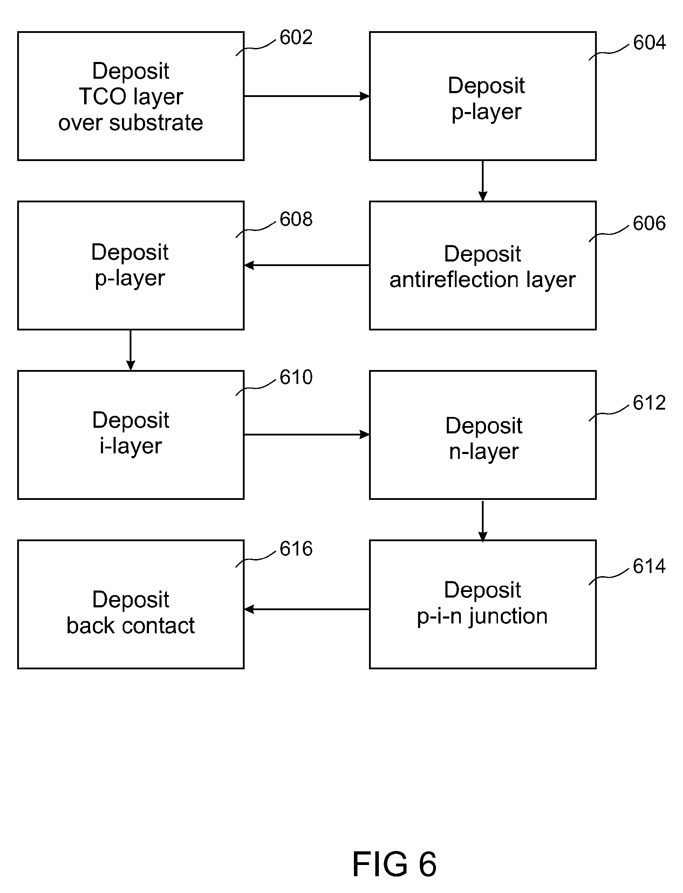

Typical embodiments of a solar cell precursor, such as a layer stack for a thin-film solar cell and the manufacturing thereof, are illustrated in figures 5A to 5H and in figure 6. As shown in figure 5A, a buffer layer 103 is deposited on the substrate 102. Thereafter, the TCO layer 104, for example a doped ZnO layer, is provided over the substrate as indicated by step 602 in figure 6. Figure 5A shows the TCO layer 104 being textured for improved light trapping. Typically, a doped ZnO layer is deposited by a DC-sputtering process as a TCO front contact with a thickness of about 800 - 1000 nm. The dopant can be, but is not limited to, aluminum. Finally, the layer stack is etched in diluted acid in order to roughen the ZnO surface by wet etching. The textured transparent conductive oxide layer can have a layer thickness of, for example, 400 nm to 700 nm, typically 400 nm to 600 nm, wherein the thickness of the texture surface is measured with X-ray fluorescence (XRF).

Examples of a TCO layers, particularly ZnO-containing TCO layers are described in patent application Ser. No. 12/854,469, entitled "Thin film solar fabrication process, deposition method for TCO layer, and solar cell precursor layer stack" filed August 11, 2010 and U.S. patent application Ser. No. 12/840,039, entitled " Thin Film Solar Fabrication Process, Deposition method for TCO layer, and Solar cell precursor layer stack" filed July 20, 2010, both of which are incorporated herein by reference to the extent the applications are not inconsistent with this disclosure.
In step 604, a layer 506 of the first conductive-type such as a µc-Si(p)-layer is deposited on the doped and textured ZnO layer. Typically, the µc-Si(p)-layer can have a layer thickness of 2 nm to 10 nm. Thereafter, as shown in Fig. 5C, an anti-reflection layer 505 is deposited in step 606. According to embodiments described herein, the anti-reflection layer 505 is a SiOx layer, which is deposited by a CVD process, such as PECVD. Typically, the SiOx anti-reflection layers as described herein can be deposited by flowing a gas mixture comprising at least silane, phosphine, hydrogen and CO₂ in a deposition region of the chemical vapor deposition process. According to yet further implementations, silicon can also be provided by flowing disilane, SiCl4 or other choro-fluorosilanes in a deposition region. Further, oxygen might also be provided by flowing N₂O in a deposition region.

The SiOx layer can have a thickness of, for example, 5 nm to 40 nm. Even though not shown in all detail in Fig. 5C, according to some embodiments, which can be combined with other embodiments described herein, the SiOx-containing anti-reflection layer 505 can include several anti-reflection layers or anti-reflection sub-layers. According to a typical modification, these layers can be µc(p)-SiOx, µc(p)SiC, nc(p)SiOx, nc(p)SiC, a(p)-SiOx, and a(p)SiC. Thereby, the crystalline fraction is reduced continuously, e.g., by increasing the CO2 during the CVD process from the µc-layer to the a-layer. Thus, the one or more SiOx-containing layers can be deposited by adding CO₂ in the processing region of the CVD processing chamber. Typically, the stack of anti-reflection layers can have a thickness of about 10 nm to 50 nm.

Typically, by variation of the oxygen content in the anti-reflection layers various properties of the layer can be tuned. For example, the CO2 content in the process gas can be varied for optimizing the process and can typically be in a range of 50 sccm to 300 sccm for manufacturing a GEN 5 module, which results in about 35 sccm/m² substrate area to about 210 sccm/m² substrate area. By increasing the CO2 concentration in the processing region as described above, the crystalline fraction is reduced from about 0.16 to 0. Further, parameters such as the refraction index can be increased by varying one of the parameters of the oxygen content, the p-doping level, the silane gas flow, the methane gas flow, and/or the RF power during CVD deposition (e.g., PECVD deposition).

In step 608, a further conductive-type layer 507 (see, e.g., Fig. 5D) having the same conductive-type as the layer 506 is provided. For example, the layer 507 can be an a-Si(p)-layer, which is deposited over an a(p)-SiOx layer described above as part of the anti-reflection layer 505 or as a further ani-reflection layer. In step 610, an i-type layer 108 (see Fig. 5E), which acts as an absorber layer in the top cell, is deposited by PECVD before an n-type layer 110 (see Fig. 5F) is deposited in step 612. Thereby, a first p-i-n junction is deposited including layers 506, 505, 507, 108, and 110.

A second p-i-n junction including p-layer 114, i-layer 118, and n-layer 120 is deposited in step 614 before the back contact 124 is deposited in step 616. Further details with regard to the second p-i-n junction 428 have been described above with respect to figure 1B.

According to typical embodiments described herein, which may be combined with other embodiments described herein, the anti-reflection layer, the anti-reflection layers, or the anti-reflection sub-layers can have at least one of the following characteristics selected from the group consisting of: a refraction index of 2.6 to 3.0 or a respective refraction index grading, a (combined) thickness of 15 nm to 30 nm, a crystalline fraction of 30% to 0%, or a respective grading of the crystalline fraction, a doping or a respective grading of the doping, particularly a doping with boron or a respective grading of the doping level with boron, and a conductivity of 10⁻⁴ S/cm to 10⁻⁸ S/cm. According to typical embodiments for manufacturing the layer stack, at least one of the steps can be provided, which are selected from the group: providing a CO₂ gas flow of 70 sccm to 120 sccm, e.g. for a Gen 5 module, providing a ratio of CO₂/silane gas flow of 0.7 to 1.3, and providing RF power of 2000W to 7000W for the CVD process, e.g. for a Gen 5 module.

Some of the above described embodiments refer to a single junction or a tandem junction having a first and a second p-i-n junction, e.g., a top cell and a bottom cell, and an anti-reflection layer. However, this is not to be understood as limiting to the invention. According to modifications thereof, additionally a third, forth, or fifth p-i-n junction can be provided, wherein according to typical modifications between one or more boundaries of the further p-i-n junctions a corresponding WSR layer can be provided.

According to embodiments described herein, a precursor for a solar cell is deposited on an industrially-relevant scale. For example, the layers of some embodiments described herein can be deposited on an area of 1 m² and above, 4 m² and above, or 5 m² and above. Thereby, the surface on which the layers are to be deposited and the layers themselves need to be provided with a predetermined uniformity on a large scale. According to some embodiments, which can be combined with other embodiments described herein, the solar cell precursors, the layer stacks for solar cells, and the methods and devices for manufacturing layers can be utilized for large-area thin films. For example, substrate sizes of 1.43 m² (Gen5) and above, such as 5.7 m² (Gen8.5) or larger, can be realized.

According to embodiments described herein, it is possible to deposit anti-reflections layers, particularly of a first conductive-type anti-reflection layer such as a p-type antireflections layer within a chemical vapor deposition process for manufacturing a solar cell layer stack. Thereby, reflection of photons at the TCO/solar cell-interface can be reduced in a cost efficient way that can be applied on large area substrates as referred to in some embodiments herein. Further, as described above, the layer properties of the SiOx-containing material such as, for example, band gap, refraction index, conductivity, and crystal fraction can be tuned in large ranges in order to provide the desired electrical and optical properties or electrical and optical property gradings.

Embodiments described herein have been shown to reduce the reflectivity from about 9% for a layer stack without antireflection layer to about 7% with an antireflection layer, which is provided according to embodiments described herein, in the visible wavelength range. Further, an increase of ISC and UOC could be provided by introducing a µc(p)-SiOx layer. This improvement could also be kept up by providing a gain in absolute efficiency of about 0.3%, which is based on an increased top cell current and an increased bottom cell current.

According to yet further embodiments, which can be combined with other embodiments described herein, the doped SiOx layers (p- or n-doped) with the above described anti-reflection properties and the ability to be tuned for anti-reflection purposes can also be used for other applications, particularly electro-optical applications such as diodes or thin film transistors.

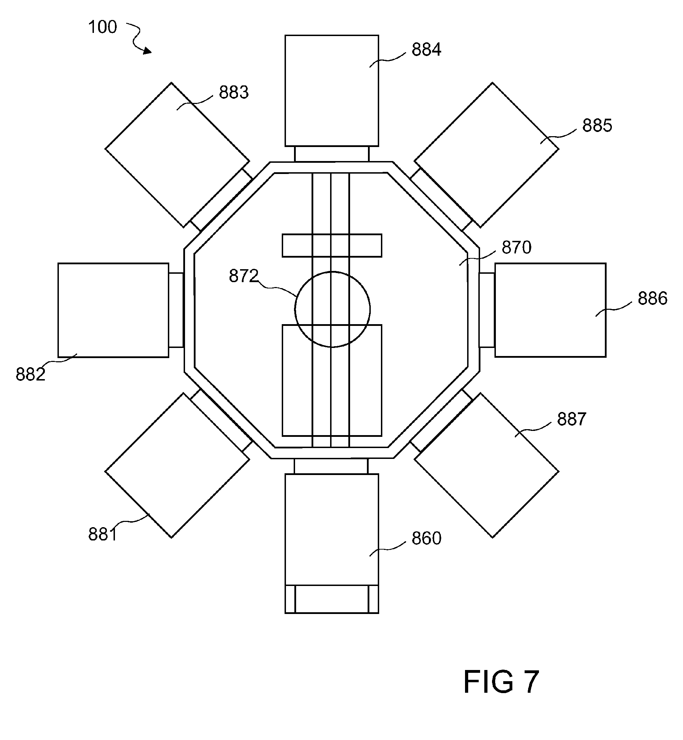

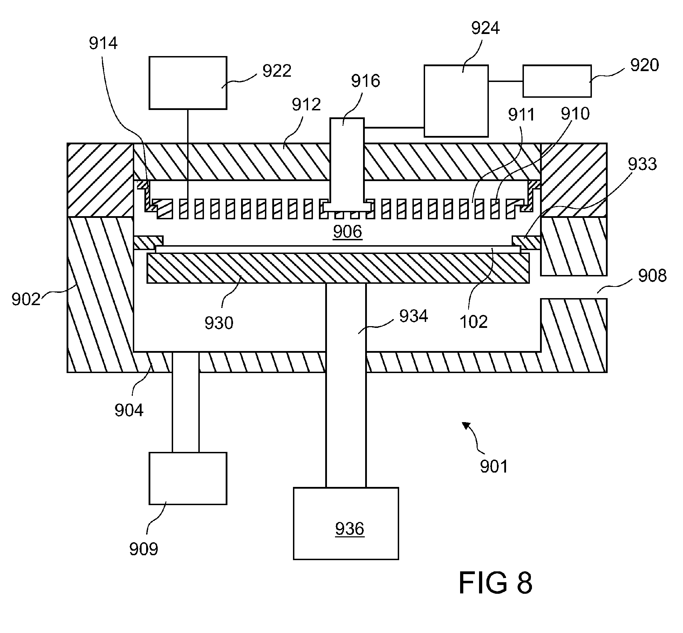

Figures 7 and 8 illustrate a processing system 800 and a processing chamber 901 that may be used to form a portion of the solar cell, discussed above. Figure 7 is a top schematic view of one embodiment of a processing system 800, which may be one of the one or more cluster tools. The processing system 800 can thus be used to perform one or more processing steps that are used to form the various layers or regions of the solar cell device. The processing system 800 will generally contain a plurality of process chambers 881-887, such as a plasma enhanced chemical vapor deposition (PECVD) chamber 901 (Figure 8), capable of depositing one or more desired layers onto the substrate surface. The process system 800 includes a transfer chamber 870 coupled to a load lock chamber 860 and the process chambers 881-887. The load lock chamber 860 allows substrates to be transferred between the ambient environment outside the system and the vacuum environment within the transfer chamber 870 and process chambers 881-887. The load lock chamber 860 includes one or more evacuatable regions holding one or more substrates. The evacuatable regions are pumped down during input of substrates into the system 800 and are vented during output of the substrates from the system 800. The transfer chamber 870 has at least one vacuum robot 872 disposed therein that is adapted for transferring substrates between the load lock chamber 860 and the process chambers 881-887. While seven process chambers are shown in Figure 7, the system 800 may have any suitable number of process chambers.

Figure 8 is a schematic cross-section view of one embodiment of a processing chamber, such as a PECVD chamber 901, in which one or more films of a solar cell may be deposited. One suitable plasma enhanced chemical vapor deposition chamber is available from Applied Materials, Inc., located in Santa Clara, CA. It is contemplated that other deposition chambers, such as hot wire chemical vapor deposition (HWCVD), low-pressure chemical vapor deposition (LPCVD), physical vapor deposition (PVD), evaporation, or other similar devices, including those from other manufacturers, may be utilized to practice the present invention. In one embodiment, the chamber 901 generally includes walls 902, a bottom 904, a showerhead 910, and a substrate support 930 which define a process volume 906. The process volume is accessed through a valve 908 such that the substrate, such as substrate 102, may be transferred in and out of the PECVD chamber 901. The substrate support 930 includes a substrate receiving surface for supporting a substrate and stem 934 coupled to a lift system 936 to raise and lower the substrate support 930. A shadow frame 933 may be optionally placed over the periphery of the device substrate that may already have one or more layers formed thereon, for example, the TCO layer. Lift pins can be moveably disposed through the substrate support 930 to move a substrate to and from the substrate receiving surface. The substrate support 930 may also include heating and/or cooling elements to maintain the substrate support 930 at a desired temperature. The substrate support 930 may also include grounding straps to provide RF grounding at the periphery of the substrate support 930. Examples of grounding straps are disclosed in U.S. Patent 6,024,044 issued on Feb. 15, 2000 to Law et al. and U.S. Patent Application 11/613,934 filed on Dec. 20, 2006 to Park et al., which are both incorporated by reference in their entirety to the extent not inconsistent with the present disclosure.

The showerhead 910 is coupled to a backing plate 912 at its periphery by a suspension 914. The showerhead 910 may also be coupled to the backing plate by one or more center supports 916 to help prevent sag and/or to control the straightness/curvature of the showerhead 910. A gas source 920 is coupled to the backing plate 912 to provide gas through the backing plate 912 and through the plurality of holes 911 in the showerhead 910 to the substrate receiving surface. A vacuum pump 909 is coupled to the PECVD chamber 901 to control the process volume 906 at a desired pressure. An RF power source 922 is coupled to the backing plate 912 and/or to the showerhead 910 to provide an RF power to the showerhead 910 so that an electric field is created between the showerhead and the substrate support so that a plasma may be generated from the gases between the showerhead 910 and the substrate support 930. Various RF frequencies may be used, such as a frequency between about 0.3 MHz and about 200 MHz. In one embodiment, the RF power source is provided at a frequency of 13.56 MHz. Examples of showerheads are disclosed in U.S. Patent 6,477,980 issued on November 12, 2002, to White et al., U.S. Publication 20050251990 published on November 17, 2006, to Choi et al., and U.S. Publication 2006/0060138 published on March 23, 2006, to Keller et al, which are all incorporated by reference in their entirety to the extent not inconsistent with the present disclosure.

A remote plasma source 924, such as an inductively coupled remote plasma source, may also be coupled between the gas source and the backing plate. Between processing substrates, a cleaning gas may be provided to the remote plasma source 924 so that a remote plasma is generated and provided to clean chamber components. The cleaning gas may be further excited by the RF power source 922 provided to the showerhead. Suitable cleaning gases include but are not limited to NF3, F2, and SF6. Examples of remote plasma sources are disclosed in U.S. Patent 5,788,778 issued August 4, 1998 to Shang et al, which is incorporated by reference to the extent not inconsistent with the present disclosure.

Referring back to Figure 7, in one embodiment of the system 800, one of the process chambers 881-887 is configured to deposit a p-type silicon layer(s) of a first p-i-n junction 126 or a second p-i-n junction 128 of a solar cell device, another one of the process chambers 881-887 is configured to deposit an intrinsic silicon layer of the first or the second p-i-n junction, and another of the process chambers 881-887 is configured to deposit the n-type silicon layer(s) of the first or the second p-i-n junction. While a three chamber process configuration may have some contamination control advantages, it will generally have a lower substrate throughput than a two chamber processing system, and generally cannot maintain a desirable throughput when one or more of the processing chambers is undergoing maintenance.

In one embodiment, which can be combined with other embodiments described herein, one of the process chambers 881-887 is configured to deposit the p-type silicon layer(s) of the first p-i-n junction while the remaining process chambers 881-887 are each configured to deposit both the intrinsic-type amorphous silicon layer(s) and the n-type silicon layer(s) of the first p-i-n junction. In one embodiment, the intrinsic-type amorphous silicon layer(s) and the n-type silicon layer(s) of the first p-i-n junction 126 may be deposited in the same chamber without performing a passivation process, which is used to minimize cross-contamination between the deposited layers, in between the deposition steps. While the discussion of the processing system 800 and its components references its use in forming the various elements of the first p-i-n junction, this configuration is not intended to be limiting as to the scope of the invention described herein, since the processing system 800 could be adapted to form the first p-i-n junction, the second p-i-n junction, both the first and second pi-n junctions, the intermediate layer, or other combinations thereof without deviating from the basic scope of the invention described herein.

In one example, in which the substrate processing sequence is performed in a system configured similarly to the processing system 800, a substrate enters the processing system 800 through the load lock chamber 860. The substrate is then transferred by the vacuum robot 872 into the process chamber 881 that is configured to deposit a p-type silicon layer(s) on the substrate. After depositing the p-type layer in process chamber 881, the substrate is then transferred by the vacuum robot 872 into the process chamber 884 that is configured to deposit both the intrinsic-type silicon layer(s) and the n-type silicon layer(s). After depositing the intrinsic-type layer(s) and n-type layer(s) in process chamber 884, the intermediate layer is deposited after the substrate is transferred to chamber 885, before a second p-i-n junction is deposited and the substrate is returned to the load lock chamber 460, after which the substrate can be removed from the system. Assuming that the p-type layer is 150Å in thickness and the deposition rate is 500Å per minute, the period of time to deposit the p-type layer is approximately 0.3 minutes. For an intrinsic layer of 2,700Å at a deposition rate of 220Å/min., the time period to deposit the intrinsic layer is approximately 12.3 minutes. Assuming an n-type layer of 250Å at a deposition rate of 500Å per minute, it will require approximately 0.5 minute to deposit the n-type layer. It can therefore be seen that if one chamber is dedicated to the deposition of a p-type layer and multiple chambers are dedicated to the deposition of the intrinsic and n-type layers, an increased throughput of substrates can be realized by increasing the number of processing chambers that can produce the i-n layers in parallel. That is, a continuous series of substrates can be loaded and maneuvered by the transfer chamber 870 from a process chamber that is adapted to deposit a p-type layer, such as process chamber 881, and then each of the substrates can be transferred to at least one subsequent processing chamber, such as process chambers 882 through 848 and 846 to 487 to form the i-n layers.

In light of the above, a plurality of embodiments has been described. According to one embodiment, a method of manufacturing a layer stack configured for an optoelectronic conversion module, such as a thin-film solar cell is provided. The method includes depositing a TCO layer over a transparent substrate and depositing a first conductive-type layer, wherein the depositing includes providing for a first SiOx-containing anti-reflection layer by chemical vapor deposition. The method further includes depositing a first intrinsic-type layer, and depositing a further conductive-type layer with a conductivity opposite to the first conductive-type layer. According to typical modifications thereof, the depositing the first conductive-type layer can further include: providing a further layer of the first conductive-type. Thereby, the first anti-reflection layer can be provided within the further layer of the first conductive-type or between the TCO layer and the further layer of the first conductive-type. According to yet further embodiments, which can be combined with other embodiments described herein, the SiOx-containing layer and the further layer can be of the first conductive-type, e.g. the method can further include doping the further layer of the first conductive-type as a p-doped layer and doping the first anti-reflection layer as a p-doped layer. According to yet further alternative or additional implementations, the method may further include depositing at least a further anti-reflection layer by chemical vapor deposition within the a first conductive-type layer or between the TCO layer and the first conductive-type layer; the first anti-reflection layer can be deposited to have a refraction index which is between the refraction index of the TCO layer provided in direction of a first side of the first anti-reflection layer and the refraction index of another layer in direction of a side of the first anti-reflection layer opposing the first side; the depositing of the first anti-reflection layer can include flowing a gas mixture comprising at least silane, phosphine, hydrogen and CO2 in a deposition region of the chemical vapor deposition process; and/or the depositing of the further anti-reflection layer can include flowing a gas mixture comprising at least silane, phosphine, hydrogen and CO2 in a deposition region of the chemical vapor deposition process.

According to another embodiment, a precursor for an optoelectronic conversion module is provided. The precursor includes a transparent substrate, a TCO layer deposited over the substrate, a first conductive-type layer, wherein the first conductive-type layer includes: a first SiOx-containing anti-reflection layer deposited by chemical vapor deposition. The precursor further includes a first intrinsic-type layer and a further conductive-type layer with a conductivity opposite to the first conductive-type layer. According to yet further embodiments, which can be combined with other embodiments described herein, the first conductive-type layer can be a p-doped layer; the first SiOx-containing anti-reflection layer can be a doped layer, e.g. a p-doped layer; and/or the first anti-reflection layer can have a refraction index which is between the refraction index of the TCO layer provided in direction of a first side of the first anti-reflection layer and the refraction index of another layer in the direction of a side of the first anti-reflection layer opposing the first side. According to yet further alternative or additional modifications, the precursor can further include at least a further anti-reflection layer deposited by chemical vapor deposition within the first conductive-type layer or between the TCO layer and the first conductive-type layer, e.g., a further anti-reflection layer being a p-doped layer, which can as a further alternative or additional option be
selected from the group consisting of: a µc-SiOx.-containing layer, a µc SiC-containing layer, a nc-SiOx containing layer, a nc SiC-containing layer, a amorphous SiOx-containing layer, and a amorphous SiC-containing layer. According to yet further embodiments, which can be combined with other embodiments described herein, the crystal fraction of the further anti-reflection layer can be higher than the crystal fraction of the first anti-reflection layer and/or the refraction index of the further anti-reflection layer can be lower than the refraction index of the first anti-reflection layer.

While the foregoing is directed to embodiments of the present invention, other and further embodiments of the invention may be devised without departing from the basic scope thereof, and the scope thereof is determined by the claims that follow.

## Claims

1. A method of manufacturing a layer stack configured for an optoelectronic conversion module, the method comprising:
depositing a TCO layer over a transparent substrate;
depositing a first conductive-type layer, the depositing-comprises: providing for a first SiOx-containing anti-reflection layer by chemical vapor deposition;
depositing a first intrinsic-type layer; and
depositing a further conductive-type layer with a conductivity opposite to the first conductive-type layer.

2. The method according to claim 1, wherein the depositing the first conductive-type layer further comprising: providing a further layer of the first conductive-type, and wherein the first anti-reflection layer is provided within the further layer of the first conductive-type or between the TCO layer and the further layer of the first conductive-type.

3. The method according to any of claims 1 or 2, further comprising: doping the further layer of the first conductive-type as a p-doped layer and doping the first anti-reflection layer as a p-doped layer.

4. The method according to any of claims 1 to 3, further comprising:
depositing at least a further anti-reflection layer by chemical vapor deposition within the a first conductive-type layer or between the TCO layer and the first conductive-type layer.

5. The method according to any of claims 1 to 4, wherein the first anti-reflection layer is deposited to have a refraction index which is between the refraction index of the TCO layer provided in direction of a first side of the first anti-reflection layer and the refraction index of another layer in direction of a side of the first anti-reflection layer opposing the first side.

6. The method according to any of claims 1 to 5, wherein the depositing of the first anti-reflection layer comprises:
flowing a gas mixture comprising at least silane, boron-containing gas, hydrogen and CO2 in a deposition region of the chemical vapor deposition process.

7. The method according to any of claims 3 to 6, wherein the depositing of the further anti-reflection layer comprises:
flowing a gas mixture comprising at least silane, boron-containing gas, hydrogen and CO2 in a deposition region of the chemical vapor deposition process.

8. A precursor for an optoelectronic conversion module, comprising:
a transparent substrate;
a TCO layer deposited over the substrate;
a first conductive-type layer, wherein the first conductive-type layer comprises: a first SiOx-containing anti-reflection layer deposited by chemical vapor deposition;
a first intrinsic-type layer; and
a further conductive-type layer with a conductivity opposite to the first conductive-type layer.

9. The precursor according to claim 8, wherein the first conductive-type layer is a p-doped layer.

10. The precursor according to any of claims 8 to 9, wherein the first anti-reflection layer has a refraction index which is between the refraction index of the TCO layer provided in direction of a first side of the first anti-reflection layer and the refraction index of another layer in the direction of a side of the first anti-reflection layer opposing the first side

11. The precursor according to any of claims 8 to 10, further comprising:
at least a further anti-reflection layer deposited by chemical vapor deposition within the first conductive-type layer or between the TCO layer and the first conductive-type layer, and wherein the first anti-reflection layer is provided between the further anti-reflection layer and the substrate.

12. The precursor according to claim 11, wherein the further anti-reflection layer is a p-doped layer.

13. The precursor according to any of claims 11 to 12, wherein the further anti-reflection layer is selected from the group consisting of: a µc-SiOx.-containing layer, a µc SiC-containing layer, a nc-SiOx containing layer, a nc SiC-containing layer, a amorphous SiOx-containing layer, and a amorphous SiC-containing layer.

14. The precursor according to any of claims 11 to 13, wherein the crystal fraction of the further anti-reflection layer is lower than the crystal fraction of the first anti-reflection layer.

15. The precursor according to any of claims 11 to 14, wherein the refraction index of the further anti-reflection layer is higher than the refraction index of the first anti-reflection layer.
